**Europäisches Patentamt**

(19) **European Patent Office**

**Office européen des brevets**

(11) Veröffentlichungsnummer: **0 113 848 B1**

(12) **EUROPÄISCHE PATENTSCHRIFT**

(45) Veröffentlichungstag der Patentschrift:
**10.12.86**

(51) Int. Cl.⁴: **B 66 B 1/28,** H 02 P 7/00

(21) Anmeldenummer: **83112134.8**

(22) Anmeldetag: **02.12.83**

(54) Datenein- und -ausgabeeinrichtung für eine mittels Digitalrechner betriebene Antriebsregelungseinrichtung.

(30) Priorität: **20.12.82  CH 7418/82**

(43) Veröffentlichungstag der Anmeldung:
**25.07.84 Patentblatt 84/30**

(45) Bekanntmachung des Hinweises auf die Patenterteilung:
**10.12.86 Patentblatt 86/50**

(84) Benannte Vertragsstaaten:
**AT BE DE FR GB IT NL**

(73) Patentinhaber: **INVENTIO AG, Seestrasse 55, CH-6052 Hergiswil NW (CH)**

(72) Erfinder: **Kindler, Gerhard, Baumschulweg 16, CH-6045 Meggen (CH)**
Erfinder: **Stanyard, Ray, Buchfeldstrasse 19, CH-6033 Buchrain (CH)**

(56) Entgegenhaltungen:
EP - A - 0 026 406
US - A - 4 346 434

REGELUNGSTECHNIK, Band 30, Nr. 11, November 1982, Seiten 378-387, München, DE. P. MAGYAR et al: "Digitale Regelung und Steuerung einer stromrichtergespeisten Gleichstrommaschine mit Mikrorechner"
REVUE GENERALE DE L'ELECTRICITE, Nr. 1, Januar 1982, Seiten 1-11, Paris, FR. H. LE HUY et al: "Commande numérique d'une machine synchrone autopilotée par microprocesseur"
PATENTS ABSTRACTS OF JAPAN, Band 6, Nr. 41, 13. März 1982, Seite 121P106
PROCEEDINGS OF THE INSTITUTION OF ELECTRICAL ENGINEERS, Band 119, Nr. 3, März 1972, Seiten 335-336,

(56) Entgegenhaltungen: (Fortsetzung)
Stevenage, GB. Y.G. PAITHANKAR et al: "Improved pulse-forming circuit for protective relays"
ELECTRONIC DESIGN, Band 16, Nr. 1, 4. Januar 1968, Seiten 144-144a, Rochelle Park, USA R. BILLON: "Zero-crossing detector needs no supply voltage"
IBM TECHNICAL DISCLOSURE BULLETIN, Band 14, Nr. 2, Juli 1971, Seite 383, New York, USA O.R. BUHLER: "Pulser"
ELECTRONIC INDUSTRIES, Band 24, Nr. 6, Juni 1965, Seite 152, Radnor, USA "Circuit features zero-level clipping"

## Beschreibung

Die Erfindung betrifft eine Datenein- und -ausgabeeinrichtung für eine mittels Digitalrechner betriebene Antriebsregelungseinrichtung mit Weg-, Geschwindigkeits- und Stromregelkreis und Stellgliedern in Form von Thyristoren, wobei die Datenein- und -ausgabeeinrichtung einen mit einem Digitaltachometer verbundenen Wegzähler, einen mit einem weiteren Digitaltachometer verbundenen Geschwindigkeitszähler, einen Ausgabebaustein, in dem vom Digitalrechner errechnete Zünddaten übertragen werden und eine Synchronisationseinrichtung aufweist, und wobei Unterbrechungsanforderungen erzeugt werden, mittels welchen Interruptprogramme für die Datenein-ausgabe und den Regelvorgang aufgerufen werden.

Bei einer bekannten, mittels Digitalrechner betriebenen Antriebsregelungseinrichtung nach der DE-PS 1302194 erfolgt die Datenausgabe für den Geschwindigkeits- und den Wegregelkreis über je einen ausgangsseitig mit einem Regler verbundenen DA-Wandler, so dass dem Stellglied die Stellgrösse in analoger Form zugeführt wird. Bei Stabilisierung derartiger Regelungseinrichtungen mittels eines dem Geschwindigkeitsregelkreis unterlagerten Stromregelkreises und Übernahme der Reglerfunktion durch den Digitalrechner, müsste gemäss der angewendeten konventionellen Technik für die Eingabe des Stromistwertes ein Stromwandler und ein AD-Wandler vorgesehen werden. Wird für den Antrieb ein mittels Thyristoren gesteuerter Drehstrommotor verwendet, so muss der Digitalrechner ausserdem die Berechnung der Zündzeitpunkte für jede Phase, in welcher Thyristoren angeordnet sind, durchführen.

Eine in der Druckschrift Regelungstechnik, Band 30, Nr. 11, November 1982, Seiten 378–387, München, beschriebene digitale Regelung und Steuerung einer stromrichtergespeisten Gleichstrommaschine mit Mikrorechner, weist eine dem Oberbegriff ähnliche Datenein- und -ausgabeeinrichtung auf. Hierbei sind ein mit einem Impulsgeber verbundener Zähler eines Geschwindigkeitsregelkreises und ein Zündinterface ohne Anwendung von AD- bzw. DA-Wandlern am Datenbus des Mikrorechners angeschlossen. Für die Erfassung und Eingabe des Stromistwertes eines dem Geschwindigkeitsregelkreis unterlagerten Stromregelkreises sind ein Stromwandler, ein Integrator und ein AD-Wandler vorgesehen. Das Zündinterface arbeitet mit mindestens zwei Timern zusammen, wovon der eine die Zündeinsatzpunkte und der andere die Zündimpulsbreite bestimmt. Der Zündprozess wird mittels Interruptprogrammen von der CPU aus gesteuert. Zur Regelung und Steuerung der Gleichstrommaschine sind mehrere Interruptprogramme erforderlich. Die dafür benötigte Folge von Interruptanforderungen wird jeweils bei positivem Nulldurchgang der Phasenspannung R ausgelöst. Zu diesem Zweck ist die CPU des Mikrorechners mit einer Netzsynchronisation verbunden.

Der Hard- und Softwareaufwand vorstehend beschriebener Datenein- und -ausgabeeinrichtung kann als beträchtlich bezeichnet werden. Hierbei muss auch berücksichtigt werden, dass der Geschwindigkeits-Zählerstand in einem während der Leseoperation mittels einer geeigneten Logik vom Zähler abtrennbaren Datenpuffer zwischengespeichert werden muss, damit eine einwandfreie Übertragung des Zählerstandes gewährleistet ist.

Der Erfindung liegt die Aufgabe zugrunde, zum Zwecke der Reduzierung des Hard- und Softwareaufwandes die digitalen Weg- und Geschwindigkeitswerte ohne die üblicherweise für die Fixierung des Zählerstandes notwendigen Einrichtungen in den Digitalrechner einzugeben und den Zündprozess unabhängig von Interruptprogrammen zu steuern, die von dem Mikroprozessor aufgezwungenen Interruptanforderungen ausgelöst werden.

Diese Aufgabe wird durch die im Patentanspruch 1 gekennzeichnete Erfindung gelöst. Hierbei wird die Stellgrösse in einen programmierbaren Mehrfachzähler übertragen, dessen den einzelnen Phasen des Drehstromnetzes zugeordnete Zähler mittels einer Synchronisationseinrichtung derart steuerbar sind, dass die Thyristoren jeweils beim gleichen, der jeweiligen Stellgrösse entsprechenden Phasenwinkel gezündet werden. Der Weg- und der Geschwindigkeitszähler sind über Bustreiber direkt mit dem Datenbus des Digitalrechners verbunden, wobei bei jeder Leseoperation die Ergebnisse einer bestimmten Anzahl Ablesungen des Weg- und des Geschwindigkeitszählers gespeichert und die gültigen Werte durch ein Auswerteprogramm ermittelt werden.

Die mit der Erfindung erzielten Vorteile sind insbesondere darin zu sehen, dass der Hardwareaufwand gegenüber konventionellen Dateneinausgabetechniken beträchtlich kleiner ist und der Digitalrechner durch die vorgeschlagene Art der Datenausgabe entlastet wird. Ein weiterer Vorteil liegt darin, dass durch die mehrmalige Ablesung des Weg- und des Geschwindigkeitszählers bei jedem Eingabevorgang, Fehler, welche bei einmaliger Ablesung während transienter Vorgänge entstehen könnten, vermieden werden.

Im folgenden wird die Erfindung anhand eines auf der Zeichnung dargestellten Ausführungsbeispieles näher erläutert. Es zeigen:

Fig. 1 eine schematische Darstellung der erfindungsgemässen Datenein- und -ausgabeeinrichtung mit einer mittels eines Digitalrechners betriebenen Antriebsregelungseinrichtung;

Fig. 2 ein Schaltschema einer Synchronisationseinrichtung der Datenein- und -ausgabeeinrichtung gemäss Fig. 1;

Fig. 3 ein Diagramm des Verlaufes der Speisespannung $U_W$, der gleichgerichteten Spannung $U_G$, der Spannung an einem Triggersignalausgang T und der Spannung an einem Lenksignalausgang L der Synchronisationseinrichtung gemäss Fig. 2, und

Fig. 4 ein der Datenein- und -ausgabeeinrichtung gemäss Fig. 1 zugeordneter Intervallzeitgeber für die Erzeugung von Unterbrechungsanforderungen.

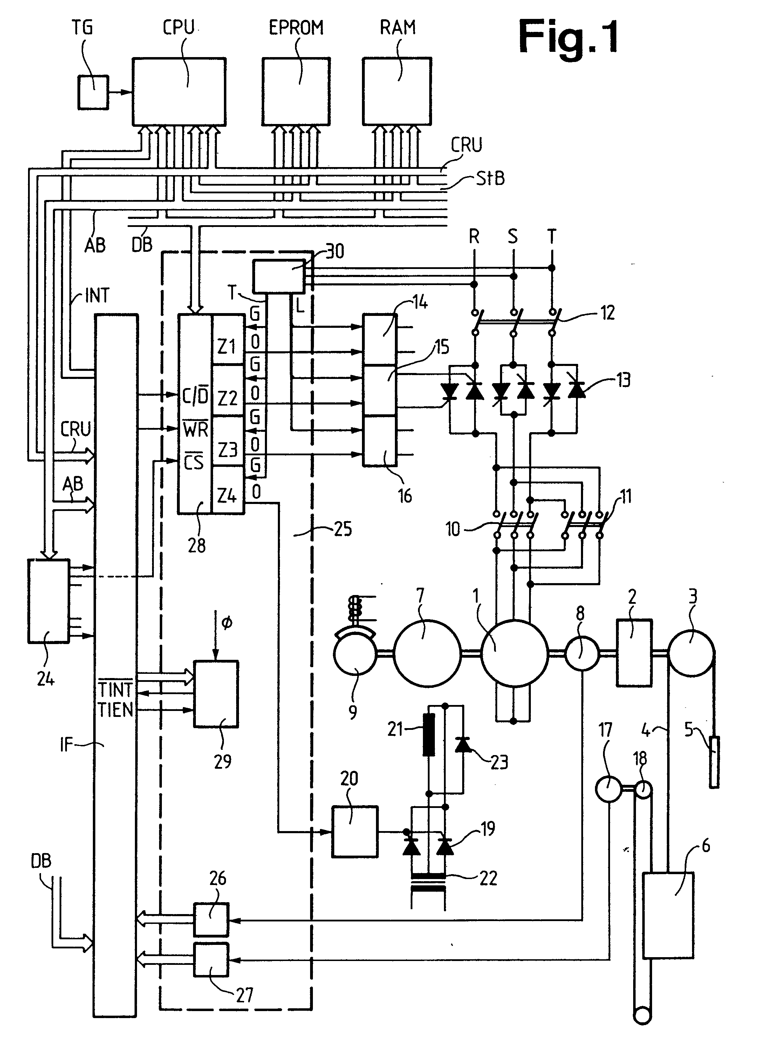

In der Fig. 1 ist mit 1 der Hubmotor eines als Anwendungsbeispiel gewählten Aufzuges bezeichnet, welcher über ein Getriebe 2 und eine Treibscheibe 3 eine an einem Förderseil 4 aufgehängte, über ein Gegengewicht 5 ausbalancierte Aufzugskabine 6 antreibt. Der Hubmotor 1, beispielsweise ein Asynchronmotor, ist mit einer Wirbelstrombremse 7, einem ersten Digitaltachometer 8 und der Bremstrommel 9 einer elektromechanischen Haltebremse gekuppelt und über Kontakte 10, 11 eines Fahrtrichtungsschützes und Kontakte 12 eines Hauptschützes an einem Drehstromnetz RST angeschlossen. Zwischen den Kontakten 10, 11 des Fahrtrichtungsschützes und den Kontakten 12 des Hauptschützes sind in jeder Phase antiparallel geschaltete Thyristoren 13 angeordnet. Die Steuerelektroden der Thyristoren 13 sind mit den Ausgängen von Treiberstufen 14, 15, 16 verbunden. Die Thyristoren 13 und die Treiberstufen 14, 15, 16 bilden das Stellglied des Hubmotors 1. Mit 17 ist ein zweiter Digitaltachometer bezeichnet, welcher von der Aufzugskabine 6 vorzugsweise über einen Geschwindigkeitsbegrenzer 18 angetrieben wird. Die Digitaltachometer 8, 17 sind einem Geschwindigkeitsregelkreis bzw. einem Wegregelkreis, sowohl des Hubmotors 1 als auch der Wirbelstrombremse 7, zugeordnet.

Ein Stellglied der Wirbelstrombremse 7 besteht aus zwei Thyristoren 19 und einer weiteren Treiberstufe 20, deren Ausgang mit den Steuerelektroden der Thyristoren 19 verbunden ist. Die Thyristoren 19, eine Erregerwicklung 21 der Wirbelstrombremse 7 und die Sekundärwicklung eines Speisetransformators 22 sind in Mittelpunktschaltung miteinander verknüpft, so dass beim Anlegen einer Wechselspannung an die Primärwicklung des Speisetransformators 22 an der Erregerwicklung 21 eine pulsierende Gleichspannung auftritt. Mit 23 ist eine parallel zur Erregerwicklung 21 geschaltete Diode bezeichnet, die bei gesperrten Thyristoren 19 einen Stromfluss durch die Erregerwicklung 21 ermöglicht. Dem Drehzahlregelkreis der Wirbelstrombremse 7 ist ein Stromregelkreis unterlagert, wobei der Erregerstromistwert, wie nachstehend anhand der Funktionsbeschreibung erläutert, ermittelt wird.

Ein als Regler arbeitender Digitalrechner, vorzugsweise in Form eines Mikrocomputers, besteht aus einem Mikroprozessor CPU, einem Festwertspeicher EPROM, einem Schreiblesespeicher RAM, einem Taktgenerator TG und einem Interface IF. Der Mikroprozessor CPU ist über einen Adressenbus AB, einen Datenbus DB und einen Steuerbus StB mit den Speichern EPROM, RAM verbunden und über einen seriellen Ein-Ausgabebus CRU, den Adressen- und Datenbus AB, DB sowie eine Interruptverbindung INT am Interface IF angeschlossen. Im Festwertspeicher EPROM sind Speicherplätze vorgesehen, in welchen der funktionelle Zusammenhang zwischen den Weg-, Geschwindigkeits- und Stromregelabweichungen und den Eingangsgrössen der Stellglieder unter Berücksichtigung der Reglercharakteristik in tabellarischer Form erfasst ist. Der Digitalrechner übt ausserdem die Funktion eines Sollwertgebers aus, wobei durch numerische Integration von im Festwertspeicher EPROM gespeicherten zulässigen Ruckwerten und Beschleunigungsgrenzwerten Wegsollwerte gebildet werden.

Das Interface IF weist einen Unterbrechungsprioritäts-Baustein auf, welcher gleichzeitig für die parallele Daten-Ein-Ausgabe geeignet ist. Er besitzt an seiner Schnittstelle zur Peripherie Interrupteingänge und einzeln adressierbare Daten-Ein-Ausgabeports. Die Interruptverbindung INT zum Mikroprozessor CPU besteht aus einem Leiter für die Unterbrechungsanforderung und vier Leitern für den Interruptcode. Bei auftretenden Unterbrechungsanforderungen definiert eine interne Prioritätslogik die Priorität der von externen Bausteinen gesendeten Interruptsignale und bildet die zur höchsten Priorität gehörige Adresse sowie den Interrupt für den Mikroprozessor CPU. Das Interface IF weist ausserdem adressierbare Mehrfach-D-Flip-Flops (adressable latches) für die Datenausgabe und Bustreiber für die Dateneingabe auf.

Mit 24 ist ein Dekodierer bezeichnet, der eingangsseitig mit dem Adressenbus AB und ausgangsseitig mit den jeweils zu identifizierenden Bausteinen des Interface IF und der Peripherie verbunden ist.

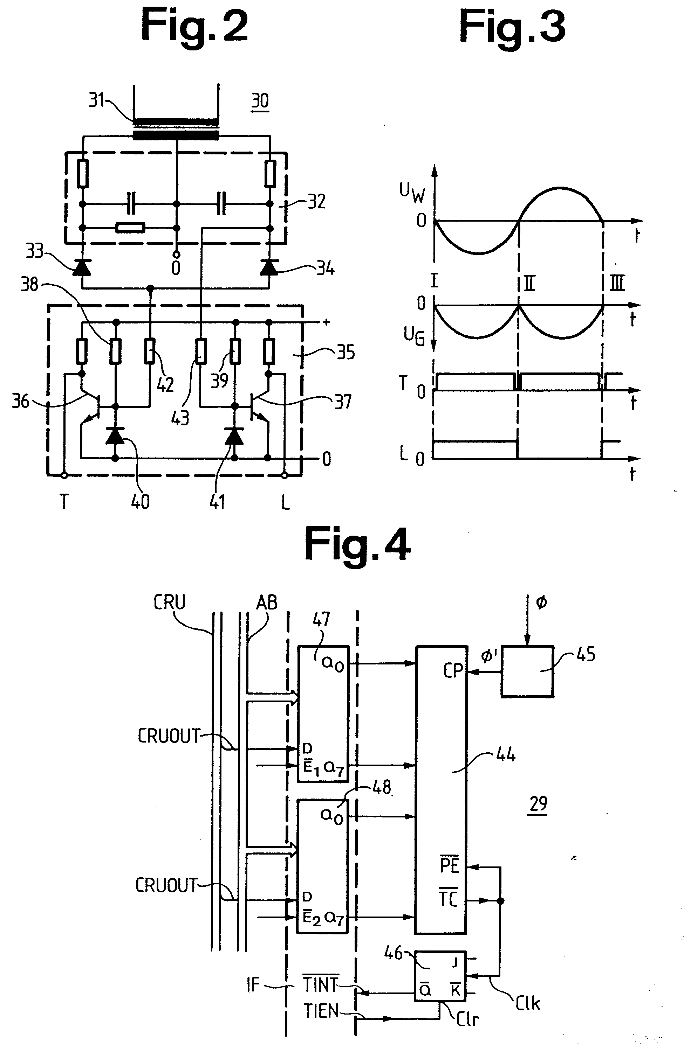

Eine Datenein- und -ausgabeeinrichtung 25 besteht aus einem Geschwindigkeitszähler 26, einem Wegzähler 27, einem programmierbaren Mehrfachzähler 28 und einem nachstehend anhand der Fig. 4 näher beschriebenen, Unterbrechungsanforderungen für den Mikroprozessor CPU erzeugenden Intervallzeitgeber 29. Der Geschwindigkeitszähler 26 und der Wegzähler 27 sind eingangsseitig an den Digitaltachometern 8, 17 angeschlossen und ausgangsseitig über Bustreiber des Interface IF mit dem Datenbus DB verbunden, wobei den Zählern 26, 27 von den Digitaltachometern 8, 17 geschwindigkeits- bzw. wegproportionale Impulsfolgen zugeführt werden. Der programmierbare Mehrfachzähler 28 ist über einen Schreib-Leseanschluss $\overline{WR}$ und einen Daten-Freigabeanschluss C/$\overline{D}$ mit dem Interface IF verbunden sowie über einen Bausteinauswahl-Anschluss $\overline{CS}$ am Dekodierer 24 und über Daten-Eingabeports am Datenbus DB angeschlossen. Über Startanschlüsse G stehen Zähler Z1–Z4 des programmierbaren Mehrfachzählers 28 mit Triggersignalausgängen T einer nachstehend anhand der Fig. 2 näher beschriebenen Synchronisationseinrichtung 30 in Verbindung. Die Überlaufanschlüsse O der Zähler Z1–Z4 sind mit den Treiberstufen 14, 15, 16, 20 verbunden, deren Ausgänge mit den Steuerelektroden der Thyristoren 13, 19 in Verbindung stehen. Die Synchronisationseinrichtung 30 ist am Drehstromnetz RST angeschlossen und über Lenksignalausgänge L mit den Treiberstufen 14, 15, 16 des Hubmotor-Stellgliedes verbunden.

Die Synchronisationseinrichtung 30 gemäss Fig. 2 besteht je Phase des Drehstromnetzes RST aus einem Transformator 31, einem aus Widerständen und Kondensatoren gebildeten Filter 32, zwei Dioden 33, 34 und einem Signalerzeuger 35. Die Anoden der Dioden 33, 34 sind miteinander verbunden, während ihre Kathoden über das Filter 32 mit den Anschlüssen der Sekundärwicklung des Transformators 31 in Verbindung stehen. Der Signalerzeuger 35 weist zwei Transistoren 36, 37 auf, deren Basen über Widerstände 38, 39 mit dem positiven Pol, und über Dioden 40, 41 mit dem Nullpotential einer Spannungsquelle verbunden sind. Die Basis des ersten Transistors 36 ist ausserdem über einen weiteren Widerstand 42 mit den Anoden der Dioden 33, 34 verbunden, die des zweiten Transistors 37 über einen weiteren Widerstand 43 an der Kathode der Diode 34 angeschlossen. Der Kollektor des ersten Transistors 36 ist mit dem Triggersignalausgang T, der des zweiten Transistors 37 mit dem Lenksignalausgang L des Signalerzeugers 35 verbunden. Ein Triggersignal T=0 wird jeweils immer dann erzeugt, wenn die an den Anoden der Dioden 33, 34 auftretende negative Gleichspannung $U_G$ auf Null gestiegen ist (Zeitpunkt I, II, III, Fig. 3). Zu diesen Zeitpunkten sperrt die Diode 40, und der erste Transistor 36 wird leitend. Während der negativen Halbwelle der sekundärseitigen Speisespannung $U_W$ ist das Lenksignal L=1, da dann die Diode 41 leitet und der zweite Transistor 37 sperrt (Zeitintervall I–II, Fig. 3). Während der positiven Halbwelle sperrt die Diode 41 und der zweite Transistor 37 ist leitend, so dass das Lenksignal L=0 ist (Zeitintervall II–III, Fig. 3).

Der Invervallzeitgeber 29 gemäss Fig. 4 besteht aus einem 16 Bit-Zähler 44, einem Frequenzteiler 45 und einem J$\overline{\text{K}}$-Flip-Flop 46. Die Dateneingänge des beispielsweise aus vier 4 Bit-Zählern gebildeten 16 Bit-Zählers 44 sind mit den Datenausgängen $Q_0$–$Q_7$ eines Zwischenspeichers 47, 48 in Form zweier adressierbarer Mehrfach-D-Flip-Flops (adressable latches) des Interface IF verbunden. Der Zwischenspeicher 47, 48 ist eingangsseitig am Adressenbus AB, am Datenausgabeleiter CRUOUT des Ein-Ausgabebusses CRU und über Freigabeanschlüsse $\overline{\text{E}}_1$, $\overline{\text{E}}_2$ am Dekodierer 24 (Fig. 1) angeschlossen. Der Ausgang des Frequenzteilers 45 ist mit einem Taktanschluss CP des 16 Bit-Zählers 44 verbunden, wobei die dem 16 Bit-Zähler 44 zugeführte Taktfrequenz $\Phi'$ beispielsweise die Hälfte der dem Eingang des Frequenzteilers 45 zugeführten Taktfrequenz $\Phi$ des Taktgenerators TG beträgt. Ein Überlaufanschluss $\overline{\text{TC}}$ und ein Ladeanschluss $\overline{\text{PE}}$ des 16 Bit-Zählers 44 sind miteinander und mit dem Taktanschluss Clk des J$\overline{\text{K}}$-Flip-Flops 46 verbunden, dessen Eingänge J, $\overline{\text{K}}$ die logischen Zustände «1» aufweisen und dessen Ausgang $\overline{\text{Q}}$ mit einem Interrupteingang $\overline{\text{TINT}}$ des Interface IF in Verbindung steht. Ein Clearanschluss Clr des J$\overline{\text{K}}$-Flip-Flops 46 ist mit einem Freigabeausgang TIEN des Interface IF verbunden.

Die vorstehend beschriebene Datenein- und ausgabeeinrichtung arbeitet wie folgt:

Bei Vorliegen eines Fahrbefehls und fahrbereiter Aufzugskabine 6 erzeugt der Mikroprozessor CPU ein Freigabesignal TIEN=1 und der 16 Bit-Zähler 44 des Intervallzeitgebers 29 beginnt mit dem Auftreten des Taktsignals $\Phi'$ zu zählen (Fig. 4). Bei Erreichen des Überlaufes erzeugt der 16 Bit-Zähler 44 ein Signal, so dass sein Überlaufanschluss $\overline{\text{TC}}$ und sein Ladeanschluss $\overline{\text{PE}}$ sowie der Taktanschluss Clk des J$\overline{\text{K}}$-Flip-Flops 46 niedrig gesetzt werden, wobei einerseits eine an den Datenausgängen $Q_0$–$Q_7$ des Zwischenspeichers 47, 48 vorhandene Binärzahl in den 16 Bit-Zähler 44 geladen wird und andererseits, da das Freigabesignal TIEN am Clearanschluss «1» ist, am Ausgang $\overline{\text{Q}}$ des J$\overline{\text{K}}$-Flip-Flops 46 eine Unterbrechungsanforderung $\overline{\text{TINT}}$=0 auftritt. Mit der nächsten ansteigenden Flanke des Taktsignals $\Phi'$, des 16 Bit-Zählers 44 beginnt dieser erneut zu zählen, wobei sein Überlaufanschluss $\overline{\text{TC}}$ und sein Ladeanschluss $\overline{\text{PE}}$ sowie der Taktanschluss Clk des J$\overline{\text{K}}$-Flip-Flops 46 auf hohes Potential gesetzt werden, ohne dass die Unterbrechungsanforderung $\overline{\text{TINT}}$=0 gelöscht wird.

Die Unterbrechungsanforderung $\overline{\text{TINT}}$ wird dem Unterbrechungsprioritäts-Baustein des Interface IF zugeleitet, in welchem die der Priorität entsprechende Adresse und die Unterbrechungsanforderung für den Mikroprozessor CPU gebildet wird. Nach Empfang der über die Interruptverbindung INT (Fig. 1) geleiteten Unterbrechungsanforderung $\overline{\text{TINT}}$ unterbricht der Mikroprozessor CPU das laufende Programm, um das durch die Adresse gekennzeichnete Interruptprogramm auszuführen. Im Rahmen dieses Programmes wird der im Wegzähler 27 enthaltene Wegistwert gelesen, der Geschwindigkeitssollwert ermittelt, der im Geschwindigkeitszähler 26 enthaltene Geschwindigkeitsistwert gelesen und die Geschwindigkeitsregelabweichung gebildet. In Abhängigkeit von dieser wird die zugeordnete Eingangsgrösse des betreffenden Stellgliedes aus dem Festwertspeicher EPROM abgerufen, wobei das Vorzeichen der Geschwindigkeitsregelabweichung entscheidet, welcher Regelpfad aktiviert wird. Um Fehler, welche durch Ablesen während transienter Vorgänge entstehen könnten zu vermeiden, werden der Geschwindigkeits- und der Wegzähler 26, 27 während eines jeden Datenabgabevorganges mehrmals abgelesen. Nach der Speicherung der abgelesenen Daten werden durch ein Auswerteprogramm die gültigen Istwerte ermittelt. Der für die Bildung der Stromregelabweichung zu ermittelnde Erregerstromistwert wird unter Berücksichtigung von im Festwertspeicher EPROM gespeicherten Konstanten der Erregerwicklung 21 in Abhängigkeit des letzten Wertes der Eingangsgrösse des Stellgliedes der Wirbelstrombremse 7 berechnet. Im Laufe des Interruptprogrammes wird in den Zwischenspeicher 47, 48 (Fig. 4) des Intervallzeitgebers 29 eine Binärzahl eingeschrieben, deren Komplement jeweils das Zeitintervall zwischen zwei Unterbrechungsanforderungen $\overline{\text{TINT}}$ bestimmt.

Die jeweils derart ermittelte Eingangsgrösse des betreffenden Stellgliedes wird nun in einer Schreiboperation in den programmierbaren Mehrfachzähler 28 übertragen. Hierbei werden vom Mikroprozessor CPU die Anschlüsse C/$\overline{\text{D}}$, $\overline{\text{CS}}$ und $\overline{\text{WR}}$ auf niedriges Potential gesetzt und die auf dem Datenbus befindliche Eingangsgrösse eingeschrieben (Fig. 1). Eine in einer vorhergehenden Operation programmierte inerte Adressierlogik bestimmt dabei, dass bei der Regelung des Hubmotors 1 in die Zähler Z1–Z3 und bei der Regelung der Wirbelstrombremse 7 in den Zähler Z4 eingeschrieben wird. Beim Eintreffen des Triggersignales T der Synchronisationseinrichtung 30 am Startanschluss G des betreffenden Zählers Z1–Z4 wird ein Zählvorgang ausgelöst, der bei Erreichen des Überlaufes mit dem Auftreten eines Impulses am Überlaufanschluss O beendet ist. Dieser Impuls wird in der betreffenden Treiberstufe 14, 15, 16, 20 verstärkt und dem zugehörigen Thyristor 13, 19 zugeführt, wobei die Dauer des Zählvorganges bis zum Überlauf den Zündzeitpunkt bestimmt und das Lenksignal L der Synchronisationseinrichtung 30 den Zündimpuls der positiven oder negativen Halbwelle der anliegenden Spannung zugeordnet.

Mit der Beendigung der Schreiboperation wird das Interruptprogramm abgeschlossen, wobei das Freigabesignal TIEN kurzzeitig auf niederes Potential geht und die Unterbrechungsanforderung $\overline{\text{TINT}}$ gelöscht wird. Der Mikrocomputer kann nun mit der Ausführung des unterbrochenen Programmes fortfahren, bis nach einem durch den Intervallzeitgeber 29 bestimmten Zeitintervall, ähnlich wie anfänglich beschrieben, die nächste Unterbrechungsanforderung $\overline{\text{TINT}}$ erzeugt wird und das gleiche Interruptprogramm erneut abläuft.

**Patentansprüche**

1. Datenein- und -ausgabeeinrichtung für eine mittels Digitalrechner betriebene Antriebsregelungseinrichtung mit Weg-, Geschwindigkeits- und Stromregelkreis und Stellgliedern in Form von Thyristoren (13, 19), wobei die Datenein- und -ausgabeeinrichtung (25) einen mit einem Digitaltachometer (17) verbundenen Wegzähler (27), einen mit einem weiteren Digitaltachometer (8) verbundenen Geschwindigkeitszähler (26), einen Ausgabebaustein, in dem vom Digitalrechner errechnete Zünddaten übertragen werden, und eine Synchronisationseinrichtung (30) aufweist, und wobei Unterbrechungsanforderungen erzeugt werden, mittels welchen Interruptprogramme für die Datenein-ausgabe und den Regelvorgang aufgerufen werden, dadurch gekennzeichnet, dass der Wegzähler (27) und der Geschwindigkeitszähler (26) über Bustreiber an einem Datenbus (DB) des Digitalrechners angeschlossen sind, wobei bei jeder Leseoperation die Ergebnisse einer bestimmten Anzahl Ablesungen des Weg- und des Geschwindigkeitszählers (27, 26) gespeichert und die gültigen Werte durch ein Auswerteprogramm ermittelt werden, dass ein an sich bekannter Intervallzeitgeber (29) vorgesehen ist, der mit einem Interrupteingang ($\overline{\text{TINT}}$) und einem Freigabeausgang (TIEN) eines Interfaces (IF) verbunden ist, und der bei Eintreffen eines vom Digitalrechner erzeugten Freigabesignales zu arbeiten beginnt und Unterbrechungsanforderungen erzeugt, dass der Ausgabebaustein ein programmierbarer Mehrfachzähler (28) ist, der über Steueranschlüsse (C/$\overline{\text{D}}$, $\overline{\text{WR}}$, $\overline{\text{CS}}$) mit dem Interface (IF) und über Dateneingänge mit dem Datenbus (DB) des Digitalrechners verbunden ist, wobei Startanschlüsse (G) der Zähler (Z1–Z4) des programmierbaren Mehrfachzählers (28) mit Triggersignalausgängen (T) der Synchronisationseinrichtung (30) in Verbindung stehen sowie Überlaufanschlüsse (O) der Zähler (Z1–Z4) und Lenksignalausgänge (L) der Synchronisationseinrichtung (30) an mit den Thyristoren (13, 19) verbundenen Treiberstufen (14, 15, 16, 20) angeschlossen sind, und wobei jeweils bei Nulldurchgang der Phasenspannungen der betreffende Zähler (Z1–Z4) zu zählen beginnt und bei Erreichen des Überlaufes ein Impuls erzeugt wird, welcher der Zündung der Thyristoren (13, 19) zugrunde gelegt wird.

2. Datenein- und -ausgabeeinrichtung nach Patentanspruch 1, dadurch gekennzeichnet, dass die Synchronisationseinrichtung (30) je Phase eines Drehstromnetzes (RST) einen Transformator (31), einen Filter (32), eine erste und eine zweite Diode (33, 34) sowie einen Signalerzeuger (35) aufweist, dass die Anoden der Dioden (33, 34) miteinander verbunden sind und ihre Kathoden über das Filter (32) mit der Sekundärwicklung des Transformators (31) in Verbindung stehen, dass der Signalerzeuger (35) zwei Transistoren (36, 37) aufweist, deren Basen über Widerstände (38, 39) mit dem positiven Pol, und über weitere Dioden (40, 41) mit dem Nullpotential einer Spannungsquelle verbunden sind, dass die Basis des ersten Transistors (36) über einen weiteren Widerstand (42) an den Anoden der Dioden (33, 34), und die Basis des zweiten Transistors (37) über einen weiteren Widerstand (43) an der Kathode der zweiten Diode (34) angeschlossen ist, und dass der Kollektor des ersten Transistors (36) mit dem Triggersignalausgang (T), der des zweiten Transistors (37) mit dem Lenksignalausgang (L) der Synchronisationseinrichtung (30) verbunden ist.

3. Datenein- und -ausgabeeinrichtung nach Patentanspruch 1, dadurch gekennzeichnet, dass für die Ermittlung des Stromistwertes des dem Geschwindigkeitsregelkreis unterlagerten Stromregelkreises in einem Festwertspeicher (EPROM) des Digitalrechners Speicherplätze vorgesehen sind, an welchen Konstanten einer Erregerwicklung (21) des Antriebes gespeichert sind, wobei der Stromistwert der Erregerwicklung (21) in Abhängigkeit des letzten Zählerstandes der Erregerwicklung (21) zugeordneten Zählers (Z4) des programmierbaren Mehrfachzählers (28) berechenbar ist.

4. Datenein- und -ausgabeeinrichtung nach Patentanspruch 1, dadurch gekennzeichnet, dass der Intervallzeitgeber (29) einen Zähler (44), einen Frequenzteiler (45) und ein J$\overline{\text{K}}$-Flip-Flop (46) aufweist, wobei die Dateneingänge des Zählers (44) mit den Datenausgängen ($Q_0$–$Q_7$) eines Zwischenspeichers (47, 48) in Form zweier adressierbarer Mehrfach-D-Flip-Flops verbunden sind, welche eingangsseitig mit einem Adressenbus (AB) und dem Datenausgabeleiter (CRUOUT) eines Ein-Ausgabebusses (CRU) des Digitalrechners in Verbindung stehen und wobei ein Überlaufanschluss (TC) und ein Ladeanschluss (PE) des Zählers (44) miteinander und mit dem Taktanschluss (Clk) des JK-Flip-Flops (46) verbunden sind, dessen Ausgang (Q̄) mit dem Interrupteingang (TINT) und dessen Clearanschluss (Clr) mit einem Freigabeausgang (TIEN) des Interface (IF) in Verbindung stehen, und dass ein Taktanschluss (CP) des Zählers (44) am Ausgang des Frequenzteilers (45) angeschlossen ist.

**Claims**

1. Data input and output equipment for a drive-regulating equipment, which is operated by means of digital computer, with circuit regulating travel, speed and current and with setting members in the form of thyristors (13, 19), wherein the data input and output equipment (25) displays a travel counter (27) connected with a digital tachometer (17), a speed counter (26) connected with a further digital tachometer (8), an output block, in which ignition data calculated by the digital computer are transmitted, and a synchronising equipment (30), and wherein interruption demands are generated, by means of which interruption programs for the data input and output and for the regulating operation are called up, characterised thereby, that the travel counter (27) and the speed counter (26) are connected by way of bus drivers to a data bus (DB) of the digital computer, wherein the results of a certain number of readings of the travel counter (27) and the speed counter (26) are stored for each readoperation and the valid values are determined through an evaluation program, that an in itself known interval time generator (29) is provided, which is connected with an interrupt input (TINT) and a release output (TIEN) of an interface (IF) and which begins to operate on the arrival of a release signal generated by the digital computer and generates interruption demands, that the output block is a programmable multiple counter (28), which is connected by way of control connections (C/D̄, WR̄, CS̄) with the interface (IF) and by way of data inputs with the data bus (DB) of the digital computer, wherein start connections (G) of the counters (Z1 to Z4) of the programmable multiple counter (28) stand in connection with trigger signal outputs (T) of the synchronising equipment (30) as well as overflow connections (O) of the counters (Z1 to Z4) and steering signal outputs (L) of the synchronising equipment (30) are connected to driver stages (14, 15, 16, 20) connected with the thyristors (13, 19), and wherein the concerned counter (Z1 to Z4) starts to count on each zero transition of the phase voltages and a pulse, which forms the basis of the ignition of the thyristors (13, 19), is generated on reaching the overflow.

2. Data input and output equipment according to patent claim 1, characterised thereby, that the synchronising equipment (30) displays one transformer (31), one filter (32), one first and one second diode (33, 34) as well as a signal generator (35) for each phase of a polyphase alternating current mains (RST), that the anodes of the diodes (33, 34) are connected together and their cathodes stand in connection by way of the filter (32) with the secondary winding of the transformer (31), that the signal generator (35) displays two transistors (36, 37), the bases of which are connected through resistors (38, 39) with the positive pole and through further diodes (40, 41) with the zero potential of a voltage source, that the base of the first transistor (36) is connected through a further resistor (42) to the anodes of the diodes (33, 34), the base of the second transistor (37) is connected through a further resistor (43) to the cathode of the second diode (34) and that the collector of the first transistor (36) is connected with the trigger signal output (T) of the synchronising equipment (30) and the collector of the second transistor (37) is connected with the steering signal output (L) of the synchronising equipment (30).

3. Data input and output equipment according to patent claim 1, characterised thereby, that for the determination of the actual current value of the current-regulating circuit underlying the speed-regulating circuit, storage places, in which the constants of an excitation winding (21) of the drive are stored, are provided in a fixed value store (EPROM) of the digital computer, wherein the actual current value of the excitation winding (21) is calculable in dependence on the last count state of that counter (Z4) of the programmable multiple counter (28), which is associated with the excitation winding (21).

4. Data input and output equipment according to patent claim 1, characterised thereby, that the interval time generator (29) displays a counter (44), a frequency divider (45) and a JK-flip-flop (46), wherein the data inputs of the counter (44) are connected with the data outputs ($Q_0$ to $Q_7$) of an intermediate store (47, 48) in the form of two adressable multiple-D-flip-flops which at the input side stand in connection with an adress bus (AB) and the data output conductor (CRUOUT) of an input-output bus (CRU) of the digital computer, wherein an overflow connection (TC) and a loading connection (PE) of the counter (44) are each connected with the other and with the pulse connection (Clk) of the JK-flip-flop (46), the output (Q̄) of which stands in connection with the interrupt input (TINT) of the interface (IF) and the clear connection (Clr) of which stands in connection with a release output (TIEN) of the interface (IF) and a pulse connection (CP) of the counter (44) is connected to the output of the frequency divider (45).

**Revendications**

1. Dispositif d'introduction et d'extraction de données pour un dispositif de régulation d'entraînement commandé par un calculateur numérique et comportant und circuit de réglage du déplacement, de la vitesse et du courant et des organes de réglage réalisés sous la forme de thyristors (13, 19), dispositif (25) d'introduction et d'extraction de données qui renferme un compteur de déplacement (27) relié à un tachymètre numérique (17), un compteur de vitesse (26) relié à un autre tachymètre numérique (8), un module de sortie, dans lequel des données d'amorçage calculées par le calculateur numérique, sont transférées, et un dispositif de synchronisation (30), et dans lequel sont produites des demandes d'interruption, à l'aide desquelles des programmes d'interruption pour l'introduction et l'extraction des données et le processus de réglage sont appelés, caractérisé en ce que: le compteur de déplacement (27) et le compteur de vitesse (26) sont raccordés, par l'intermédiaire d'un étage d'attaque de bus, à un bus de transmission de données (DB) du calculateur numérique; auquel cas, lors de chaque opération de lecture, les résultats d'un nombre déterminé de lectures du compteur de déplacements et du compteur de vitesse (27, 26) sont mémorisés et les valeurs correctes sont déterminées par un programme d'évaluation; en ce qu'il est prévu un générateur d'intervalles de temps (29), connu en soi, qui est relié à une entrée d'interruption ($\overline{\text{TINT}}$) et une sortie de validation (TIEN) d'une interface (IF) et qui entre en action à l'apparition d'un signal de validation généré par le calculateur numérique et délivre des demandes d'interruption; en ce que le module de sortie est un multi-compteur programmable (28), qui est relié, par l'intermédiaire de bornes de commande (C/$\overline{\text{D}}$, $\overline{\text{WR}}$, $\overline{\text{CS}}$) à l'interface (IF) et, par l'intermédiaire d'entrées de données, au bus de transmission de données (DB) du calculateur numérique; auquel cas des bornes de déclenchement (G) des compteurs (Z1–Z4) du multi-compteur programmable (28) sont reliées à des sorties (6) de signaux de déclenchement du dispositif de synchronisation (30), et des bornes de dépassement de capacité (O) des compteurs (Z1–Z4) et des sorties (L) de signaux pilotes du dispositif de synchronisation (30) sont raccordées à des étages d'attaque (14, 15, 16, 20) reliés aux thyristors (13, 19; et à chaque passage par zéro des tensions de phase, le compteur considéré (Z1–Z4) commence à effectuer son comptage et, lorsqu'un dépassement de capacité est atteint, une impulsion est produite, qui est à la base de l'amorçage des thyristors (13, 19).

2. Dispositif d'introduction et d'extraction de données selon la revendication 1, caractérisé en ce que le dispositif de synchronistion (30) comporte, pour chaque phase d'un réseau triphasé (RST), un transformateur (31), un filtre (32), une première et une seconde diodes (33, 34) ainsi qu'un générateur de signaux (35), en ce que les anodes des diodes (33, 34) sont reliées entre elles et que leurs cathodes sont reliées, au travers du filtre (32), à l'enroulement secondaire du transformateur (31), en ce que le générateur de signaux (35) comporte deux transistors (36, 37), dont les bases sont reliées, par l'intermédiaire de résistances (37, 39), au pôle positif et, par l'intermédiaire d'autres diodes (40, 41), au pôle de potentiel zéro d'une source de tension, en ce que la base du premier transistor (36) est raccordée, par l'intermédiaire d'une autre résistance (42), aux anodes des diodes (33, 34) et la base du second transistor (37) est raccordée, par l'intermédiaire d'une autre résistance (43), à la cathode de la seconde diode (34), et en ce que le collecteur du premier transistor (36) est raccordé à la sortie (T) de signaux de déclenchement et celui du second transistor (37) est raccordé à la sortie (L) de signaux pilotes du dispositif de synchronisation (30).

3. Dispositif d'introduction et d'extraction de données selon la revendication 1, caractérisé en ce que, pour la détermination de la valeur instantanée du courant du circuit de régulation du courant, qui est subordonné au circuit de régulation de la vitesse, il est prévu, dans une mémoire morte (EPROM) du calculateur numérique, des positions mémoires, dans lesquelles des constantes d'un enroulement d'excitation (21) du dispositif d'entraînement sont mémorisées, la valeur instantanée du courant de l'enroulement d'excitation (21) pouvant être calculée en fonction du dernier état de comptage du compteur (Z4), associé à l'enroulement d'excitation (21), du multi-compteur programmable (28).

4. Dispositif d'introduction et d'extraction de données selon la revendication 1, caractérisé en ce que le générateur d'intervalles de temps (29) comporte un compteur (44), un diviseur de fréquence (45) et une bascule bistable du type J$\overline{\text{K}}$ (46); les entrées de données du compteur (44) étant reliées aux sorties de données ($Q_0$–$Q_7$) d'une mémoire intermédiaire (46, 48) réalisée sous la forme de deux bascules bistables adressables de type D, à plusieurs sorties qui sont reliées, côté entrée, à un bus (AB) de transmission d'adresses et au conducteur (CRUOUT) d'extraction de données d'un bus d'entrée/sortie (CRU) du calculateur numérique, et une borne ($\overline{\text{TC}}$) de dépassement de capacité et une borne de chargement ($\overline{\text{PE}}$) du compteur (44) étant reliées entre elles et à la borne d'horloge (Clk) de la bascule bistable de type J$\overline{\text{K}}$ (46), dont la sortie ($\overline{\text{Q}}$) est raccordée à l'entrée d'interruption ($\overline{\text{TINT}}$) et dont la borne d'effacement (Clr) est reliée à une sortie de validation (TIEN) de l'interface (IF), et en ce qu'une borne d'horloge (CP) du compteur (44) est raccordée à la sortie du diviseur de fréquence (45).

Fig.1

# Fig.2

# Fig.3

# Fig.4